# DEMANDE DE BREVET EUROPEEN

(11) **EP 4 113 634 A1**
(43) Date de publication de la demande: **04.01.2023**
(21) Numéro de dépôt: 22180816.5
(22) Date de dépôt: 23.06.2022
(51) Int. Cl.: H01L 31/0745, H01L 31/18

(54) **PROCEDE DE REALISATION D'UNE CELLULE PHOTOVOLTAÏQUE A CONTACTS PASSIVES**

(30) Priorité: 28.06.2021 FR 2106913
(71) Demandeur: Commissariat à l'énergie atomique et aux énergies alternatives, 75015 Paris (FR)
(72) Inventeur: MARTEL, Benoît, 38054 GRENOBLE CEDEX 09 (FR); DESRUES, Thibaut, 38054 GRENOBLE CEDEX 09 (FR)
(74) Mandataire: Brevalex

(57) **Abrégé**

Procédé de réalisation d'une cellule photovoltaïque (100), comportant :
- réalisation d'une couche de passivation (108) sur une première face d'un substrat semi-conducteur (102) ;
- dépôt d'une couche semi-conductrice polycristalline (112) sur la couche de passivation ;
- implantation ionique de dopants de type p dans des premières régions de la couche semi-conductrice polycristalline ;
- recuit sous atmosphère oxydante, diffusant et activant les dopants de type p dans la couche semi-conductrice polycristalline et formant une couche d'oxyde sur la couche semi-conductrice polycristalline ;
- réalisation, sur une deuxième face du substrat et/ou sur la couche d'oxyde, d'une couche dopante (120) incluant des dopants de type n ;
- diffusion localisée des dopants de type n dans des deuxièmes régions (124) du substrat ou de la couche semi-conductrice polycristalline.

## Description

### DOMAINE TECHNIQUE

L'invention concerne le domaine de la réalisation de cellules photovoltaïques à contacts passivés, par exemple double face ou interdigités en face arrière.

### ÉTAT DE LA TECHNIQUE ANTÉRIEURE

L'intégration d'un contact passivé à base de semi-conducteur polycristallin dopé, notamment de silicium polycristallin (poly-Si), sur oxyde mince en face arrière d'une cellule photovoltaïque est une des voies d'amélioration du rendement des cellules étudiées. Une telle cellule photovoltaïque à contacts passivés (passivation réalisée par la couche d'oxyde) peut être réalisée à partir d'un substrat semi-conducteur de type n ou p.

Pour réaliser le dopage de type n d'une cellule photovoltaïque à contacts passivés, la diffusion thermique de phosphore est la méthode de dopage la plus communément utilisée dans l'industrie photovoltaïque car elle est stable, fiable, et peut être mise en œuvre avec des équipements à forte productivité.

Pour réaliser le dopage de type p de la cellule à contacts passivés, l'implantation ionique par immersion plasma (également appelée PIII ou « Plasma-Immersion Ion Implantation » en anglais) est une technique de dopage innovante, performante et très prometteuse, mais encore peu utilisée dans l'industrie photovoltaïque. Il a été proposé d'utiliser cette technique de dopage pour réaliser le dopage bore de cellules de à contacts passivés car d'une part, le dopage par diffusion thermique de bore est plus difficile à maitriser, et d'autre part, le dépôt de semi-conducteur polycristallin dopé bore in-situ présente une limitation quant à l'épaisseur de semi-conducteur pouvant être obtenue en raison des problèmes d'intégrité rencontrés lorsqu'elles sont déposées par PECVD (« Plasma Enhanced Chemical Vapor Déposition » en anglais, ou dépôt chimique en phase vapeur assisté par plasma).

Néanmoins, le dopage par diffusion thermique est une technique impliquant de mettre en œuvre un dépôt d'une ou plusieurs couches barrières pour protéger les régions de semi-conducteur de la cellule qui ne sont pas destinées à être affectées par ce dopage, et/ou de graver les régions de semi-conducteur dans lesquelles ce dopage n'est pas souhaité. De telles couches barrières comportent par exemple du SiO₂ ou du SiN, et sont déposées par PECVD. Le dépôt de telles couches barrières et/ou la gravure des régions dopées non souhaitées représentent un inconvénient pour la réalisation industrielle des cellules photovoltaïques à contacts passivés en raison.

### EXPOSÉ DE L'INVENTION

Un but de la présente invention est de proposer un procédé de réalisation de cellule photovoltaïque à contacts passivés, par exemple double face ou interdigités en face arrière, ne présentant pas les inconvénients précédemment décrits, et notamment ne nécessitant pas la réalisation d'une ou plusieurs couches barrières pour protéger certaines régions de semi-conducteur lors des étapes de dopage mises en œuvre, ou de gravure pour supprimer les régions de semi-conducteur dopé non souhaitées.

Pour cela, la présente invention propose un procédé de réalisation d'au moins une cellule photovoltaïque, comportant au moins la mise en œuvre des étapes de :
- réalisation d'une couche de passivation sur au moins une première face d'un substrat semi-conducteur;
- dépôt d'une couche de semi-conducteur polycristallin sur la couche de passivation ;
- implantation ionique de dopants de type p dans une ou plusieurs premières régions de la couche de semi-conducteur polycristallin ;
- recuit sous atmosphère oxydante, diffusant et activant les dopants de type p dans la couche de semi-conducteur polycristallin et formant au moins une couche d'oxyde de semi-conducteur sur la couche de semi-conducteur polycristallin ;
- réalisation, sur une deuxième face du substrat semi-conducteur, opposée à la première face, et/ou sur la couche d'oxyde de semi-conducteur, d'une couche dopante incluant des dopants de type n ;
- diffusion localisée des dopants de type n dans une ou plusieurs deuxièmes régions du substrat semi-conducteur ou de la couche de semi-conducteur polycristallin, la ou les deuxièmes régions étant localisées sous la couche dopante et distinctes de la ou des premières régions.

Ce procédé permet de simplifier l'élaboration des zones sur-dopées de la cellule qui fait appel à des techniques de dopage complémentaires, à savoir l'implantation ionique des dopants de type p (qui correspondent avantageusement à des atomes de bore) et la diffusion localisée des dopants de type n (qui correspondent avantageusement à des atomes de phosphore).

Dans ce procédé, la mise en œuvre du recuit sous atmosphère oxydante procure, grâce à la couche d'oxyde de semi-conducteur formée sur la couche de semi-conducteur polycristallin, un effet barrière vis-à-vis des dopants de type n qui seraient, en l'absence de cette couche d'oxyde de semi-conducteur, susceptibles d'être diffusés dans la couche de semi-conducteur polycristallin en raison des étapes mises en œuvre pour former la couche dopante et diffuser localement ces dopants, et cela sans dégrader la couche de semi-conducteur polycristallin. Ce procédé ne nécessite pas de mettre en œuvre des étapes dédiées uniquement à la protection de la couche de semi-conducteur polycristallin telles qu'un dépôt de couche de protection barrière, par exemple par PECVD, ou de mettre en œuvre une gravure chimique pour supprimer des portions de semi-conducteur dopé non souhaitées. Cette couche d'oxyde de semi-conducteur se distingue des couches barrières de l'art antérieur du fait qu'elle ne nécessite pas la mise en œuvre d'une étape de dépôt dédiée à sa réalisation.

La couche d'oxyde de semi-conducteur est conservée sur la couche de semi-conducteur polycristallin lors de la réalisation de la couche dopante et lors de la diffusion localisée des dopants de type n, ce qui permet de protéger la couche de semi-conducteur polycristallin vis-à-vis des étapes liées au dopage de type n.

Pour obtenir l'effet barrière souhaité, l'épaisseur de la couche d'oxyde de semi-conducteur est par exemple comprise entre 1 nm et 40 nm, et de préférence entre 10 nm à 40 nm.

La diffusion localisée peut être mise en œuvre directement après la réalisation de la couche dopante, sans étape de recuit de diffusion entre la réalisation de la couche dopante et la diffusion localisée. Cela permet d'éviter la diffusion des dopants du deuxième type de conductivité dans la couche de semi-conducteur polycristallin à travers la couche d'oxyde de semi-conducteur.

Les dopants de type p peuvent correspondre à des atomes de bore, et les dopants de type n peuvent correspondre à des atomes de phosphore.

De manière avantageuse, la diffusion localisée peut être mise en œuvre par laser.

Le recuit sous atmosphère oxydante peut être mis en œuvre à une température comprise entre 850°C et 1000°C et pendant une durée comprise entre 10 minutes et 60 minutes, ou entre 10 minutes et 30 minutes, et/ou la réalisation de la couche dopante peut être mise en œuvre à une température comprise entre 750°C et 850°C et pendant une durée comprise entre 5 minutes et 1 heure.

Selon une réalisation avantageuse, la couche dopante peut comporter du PSG (« Phosphorus Silica Glass » en anglais, ou verre de phosphosilicate, qui correspond à un oxyde de silicium saturé en phosphore en surface), et/ou la couche de passivation peut comporter de l'oxyde de semi-conducteur, par exemple du SiO₂.

L'atmosphère oxydante peut correspondre à une atmosphère de dioxygène.

Le substrat semi-conducteur et la couche de semi-conducteur polycristallin peuvent comporter du silicium.

La couche de semi-conducteur polycristallin peut être déposée par PECVD.

De manière avantageuse, l'implantation ionique des dopants de type p peut correspondre à une implantation ionique par immersion plasma (ou PIII). En variante, l'implantation ionique des dopants de type p peut correspondre à une implantation par faisceau d'ions (ou « Beam Line » en anglais).

Le procédé peut comporter en outre, après la diffusion localisée, un retrait de la couche d'oxyde de semi-conducteur.

Selon un premier mode de réalisation, lorsque la diffusion localisée diffuse les dopants de type n dans la ou les deuxièmes régions du substrat semi-conducteur, le procédé peut comporter en outre, après le retrait de la couche d'oxyde de semi-conducteur, un dépôt de couches antireflet du côté de la première face du substrat semi-conducteur et du côté de la deuxième face du substrat semi-conducteur, puis la réalisation, à travers les couches antireflet, d'électrodes de contact arrière sur la couche de semi-conducteur polycristallin et d'électrodes de contact avant sur les deuxièmes régions du substrat semi-conducteur. Un tel premier mode de réalisation correspond à la réalisation d'une cellule de type à contacts passivés. Dans ce cas, le procédé peut avantageusement être mis en œuvre tel que la cellule à contacts passivés double face réalisée comporte un contact passivé en silicium polycristallin dopé bore en face arrière, et un émetteur sélectif dopé phosphore en face avant. Par rapport à une cellule PERC comportant un contact aluminium face arrière localisé, la cellule obtenue comporte en face arrière un contact passivé par exemple à base de poly-Si/SiOx dopé p+.

Selon un deuxième mode de réalisation, lorsque la diffusion localisée diffuse les dopants de type n dans la ou les deuxièmes régions de la couche de semi-conducteur polycristallin, le procédé peut comporter en outre, après la diffusion localisée, un dépôt de couches antireflet du côté de la première face du substrat semi-conducteur et du côté de la deuxième face du substrat semi-conducteur, puis la réalisation, à travers l'une des couches antireflet se trouvant du côté de la première face du substrat semi-conducteur, d'au moins une première électrode de contact sur la ou les premières régions de la couche de semi-conducteur polycristallin et d'au moins une deuxième électrode de contact sur la ou les deuxièmes régions de la couche de semi-conducteur polycristallin. Un tel deuxième mode de réalisation correspond à la réalisation d'une cellule de type IBC (« Interdigitated Back Contact » en anglais, ou à contacts arrières interdigités).

Dans ce deuxième mode de réalisation, les premières et deuxièmes électrodes de contacts peuvent être interdigitées.

La réalisation des électrodes de contact avant et arrière (correspondant au premier mode de réalisation) ou la réalisation des premières et deuxièmes électrodes de contact (correspondant au deuxième mode de réalisation) comporte au moins un dépôt par impression d'une pâte de sérigraphie, puis un recuit de la pâte de sérigraphie.

Le procédé peut comporter en outre, avant la réalisation de la couche de passivation, une texturation de la première face et/ou de la deuxième face du substrat.

Dans l'ensemble du document, le terme «sur» est utilisé sans distinction de l'orientation dans l'espace de l'élément auquel ce rapporte ce terme. Par exemple, dans la caractéristique « sur au moins une première face d'un élément », cette première face n'est pas nécessairement orientée vers le haut, mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments. En outre, la disposition d'un premier élément sur un deuxième élément n'implique pas nécessairement que le premier élément soit orienté vers le haut et que le deuxième élément soit orienté vers le bas.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 9 représentent les étapes d'un procédé de réalisation d'une cellule photovoltaïque selon un premier mode de réalisation ;
- les figures 10 à 13 représentent les étapes d'un procédé de réalisation d'une cellule photovoltaïque selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

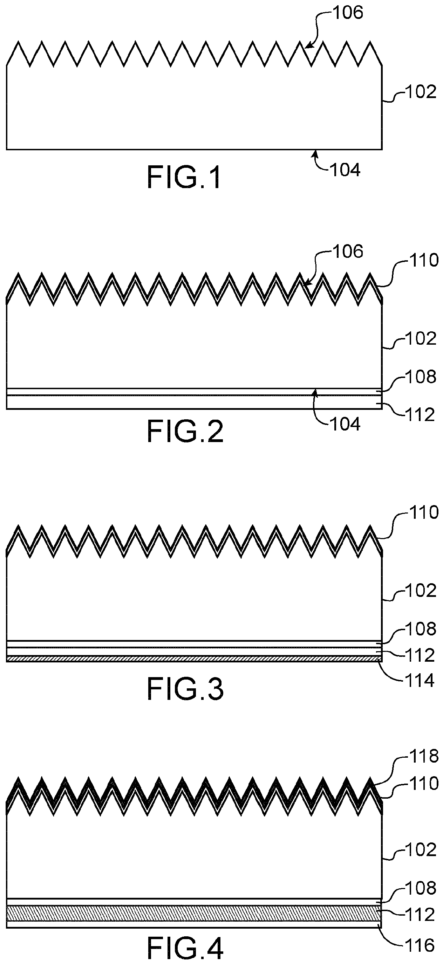

Un procédé de réalisation d'une cellule photovoltaïque 100 selon un premier mode de réalisation est décrit ci-dessous en lien avec les figures 1 à 9. Dans ce premier mode de réalisation, la cellule 100 correspond à une cellule à contacts passivés double face.

La cellule 100 est réalisée à partir d'un substrat 102 comportant du semi-conducteur. Ce semi-conducteur correspond avantageusement à du silicium polycristallin ou monocristallin. Le semi-conducteur du substrat 102 est dopé n ou p. Le substrat 102 comporte une première face 104 et une deuxième face 106 opposées l'une de l'autre. Dans l'exemple de réalisation décrit ici, la deuxième face 106 du substrat 102 est destinée à se trouver du côté de la face avant de la cellule 100, c'est-à-dire du côté de la face destinée à recevoir le rayonnement lumineux, et la première face 104 du substrat 102 est destinée à se trouver du côté de la face arrière de la cellule 100.

Une étape de texturation de la première face 104 et/ou de la deuxième face 106 du substrat 102 est mise en œuvre. Cette étape de texturation correspond par exemple à une attaque chimique ou toute autre technique de texturation d'un substrat semi-conducteur adaptée à la réalisation d'une cellule photovoltaïque. Dans l'exemple de réalisation décrit ici, les deux faces 104, 106 du substrat 102 subissent cette étape de texturation, mais un polissage de la première face 104 est ensuite mis en œuvre afin de ne conserver les texturations qu'au niveau de la deuxième face 106 (voir figure 1). En variante, il est possible de ne pas mettre en œuvre ce polissage afin de conserver les texturations réalisées au niveau de la première face 104 du substrat 102, ou bien de ne pas mettre en œuvre cette étape de texturation.

Une couche de passivation 108 est ensuite réalisée sur au moins l'une des première et deuxième faces 104, 106 du substrat 102. Dans le premier mode de réalisation décrit ici, cette couche de passivation 108 est réalisée sur la première face 104 du substrat 102. La couche de passivation 108 correspond ici à une couche d'oxyde de semi-conducteur, et plus particulièrement du SiO₂ du fait que le substrat 102 comporte du silicium. Cette couche de passivation 108 est par exemple réalisée en mettant en œuvre une oxydation thermique. L'épaisseur de la couche de passivation 108 est par exemple égale à 1,5 nm, ou par exemple comprise entre 1 nm à 2 nm. L'épaisseur de la couche de passivation 108 est telle que cette couche forme, à l'issue de la réalisation de la cellule 100, une couche tunnel permettant le passage de charges électriques par effet tunnel.

En variante, la couche de passivation 108 peut comporter un oxyde qui n'est pas un oxyde de semi-conducteur, comme par exemple de l'AIOx.

Dans l'exemple de réalisation décrit ici, du fait que la couche de passivation 108 est formée par oxydation thermique, une fine couche d'oxyde 110 similaire à la couche de passivation 108 est également formée sur la deuxième face 106 du substrat 102.

De manière alternative, la couche de passivation 108 peut être réalisée par voie chimique et/ou via une exposition à un rayonnement ultraviolet en présence d'un agent oxydant tel que de l'ozone. Toutefois, l'oxydation thermique est préférée pour la réalisation de la couche de passivation 108 en raison de la meilleure conformité conférée dans ce cas à cette couche.

Une couche 112 de semi-conducteur polycristallin (du silicium polycristallin dans l'exemple de réalisation décrit ici) est ensuite déposée sur la couche de passivation 108 (voir figure 2). Afin que ce dépôt soit localisé du côté de la couche de passivation 108 et non sur la couche 110, la couche 112 peut être déposée par PECVD. Le semi-conducteur polycristallin de couche 112 est ici intrinsèque (non dopé intentionnellement). La couche 112 est ici réalisée telle qu'elle soit suffisamment épaisse pour pouvoir être ultérieurement contactée électriquement par des électrodes de contact formées par dépôt d'une pâte de sérigraphie sans détériorer la couche de passivation 108, et suffisamment fine pour éviter une trop forte absorption de la lumière par cette couche 112. Dans l'exemple de réalisation décrit ici, la couche 112 a par exemple une épaisseur comprise entre 70 nm et 200 nm, et avantageusement une épaisseur égale à 150 nm.

Une implantation ionique, avantageusement par immersion plasma (PIII), de dopants de type p dans une ou plusieurs premières régions de la couche 112 est ensuite mise en œuvre. Dans le premier mode de réalisation décrit ici, les dopants de type p correspondent à des atomes de bore. En outre, dans le premier mode de réalisation décrit ici qui porte sur la réalisation d'une cellule photovoltaïque à contacts passivés double face, les dopants sont implantés à travers toute la face arrière de la couche 112, c'est-à-dire la face opposée à celle en contact avec la couche de passivation 108. La partie dopée obtenue de la couche 112 est désignée, sur la figure 3, par la référence 114. La dose implantée peut être comprise entre 5.10¹⁵ at/cm² et 3.10¹⁶ at/cm², et la tension d'accélération appliquée pour cette implantation peut être comprise entre 2 keV et 8 keV. A titre d'exemple, cette implantation est mise en œuvre avec une dose égale 1,5.10¹⁶ at/cm² et une tension d'accélération égale à 4 keV.

En variante, cette implantation ionique peut être mise en œuvre par faisceau d'ions.

La structure réalisée est ensuite soumise à un recuit sous atmosphère oxydante (voir figure 4). Ce recuit va permettre de diffuser dans la couche 112 les dopants précédemment implantés dans la partie 114 de cette couche 112, activer ces dopants, et également former au moins une couche d'oxyde de semi-conducteur 116 sur la couche 112. Dans l'exemple de réalisation décrit ici, du fait que la couche 112 comporte du silicium, la couche 116 comporte du SiO₂. L'épaisseur de la couche 116 est par exemple comprise entre 1 nm et 40 nm, et de préférence entre 10 nm et 40 nm. En outre, dans l'exemple de réalisation décrit ici, ce recuit sous atmosphère oxydante forme également une autre couche 118 d'oxyde de semi-conducteur sur la couche 110. Ce recuit est par exemple mis en œuvre sous atmosphère de dioxygène. La température du recuit est par exemple comprise entre 850°C et 1000°C, et avantageusement égale à 950°C, pendant une durée par exemple comprise entre 10 minutes et 60 minutes, et avantageusement égale à 30 minutes ou comprise entre 10 minutes et 30 minutes. La durée du recuit peut être ajustée en fonction de la température avec laquelle le recuit est mis en oeuvre : plus la température de mise en œuvre sera basse, plus sa durée devra être importante pour obtenir une couche 116 ayant des caractéristiques données.

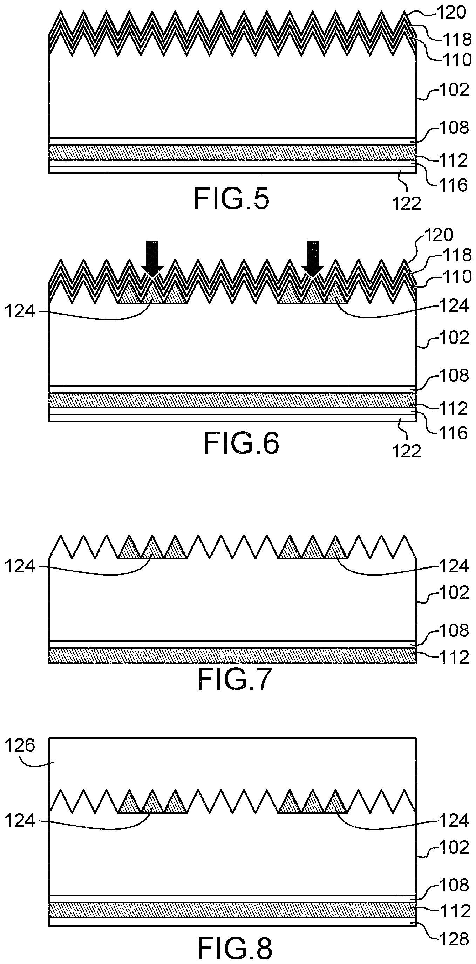

Une couche dopante 120 incluant des dopants de type n, par exemple des atomes de phosphore, est ensuite réalisée du côté de la deuxième face 106 du substrat 102 (voir figure 5). Dans l'exemple de réalisation décrit ici, en raison de la présence des couches d'oxyde 110 et 118 sur la deuxième face 106 du substrat 102, la couche dopante 120 est réalisée sur la couche d'oxyde 118. En outre, dans l'exemple de réalisation décrit ici, la couche dopante 120 correspond à une couche de PSG obtenue par exemple en mettant en œuvre une diffusion thermique à basse pression, avec un précurseur contenant du phosphore (par exemple du Trichlorure de Phosphoryle, POCl₃) et du dioxygène. Les étapes mises en œuvre pour réaliser la couche dopante 120 forment également, sur la couche d'oxyde 116, une autre couche 122 similaire à la couche dopante 120. Ces étapes sont mises en œuvre à une température par exemple comprise entre 750°C et 850°C, et par exemple égale à 770°C, pendant une durée par exemple comprise entre 5 mn et 1 heure, et par exemple égale à 20 mn. Comme pour le recuit sous atmosphère oxydante, la durée de mise en œuvre de ces étapes peut être ajustée en fonction de la température utilisée : plus la température de mise en œuvre sera basse, plus sa durée devra être importante pour obtenir une couche dopante 120 ayant des caractéristiques données.

Lors de la réalisation de la couche dopante 120, la présence de la couche d'oxyde 116 sur la couche 112 permet de préserver cette couche 112 vis-à-vis des dopants de type n (phosphore dans cet exemple de réalisation) et éviter une diffusion de ces dopants, depuis la couche 122, dans la couche 112 qui est dopée avec des dopants de type p (bore dans cet exemple de réalisation).

Une étape de diffusion, ou sur-dopage, localisée des dopants de type n dans une ou plusieurs deuxièmes régions 124 du substrat 102 est ensuite mise en œuvre (voir figure 6). La ou les deuxièmes régions 124 sont localisées sous la couche dopante 120 (et sous les couches 110 et 118 dans l'exemple de réalisation décrit ici). Dans l'exemple de réalisation décrit ici, cette étape de diffusion localisée est mise en œuvre en exposant certaines zones de la face avant de la structure réalisée à un faisceau laser, ce qui permet de fortement diffuser les atomes depuis les parties de la couche dopante 120 se trouvant dans ces zones et qui sont exposées à ce faisceau laser, jusque dans les deuxièmes régions 124 du substrat 102. Les deuxièmes régions 124 formeront des régions émettrices de la cellule 100.

Cette étape de diffusion localisée est mise en œuvre directement après la réalisation de la couche dopante 120, sans étape de recuit de diffusion, ou « drive in » en anglais, mise en œuvre entre la réalisation de la couche dopante 120 et la diffusion localisée.

Comme représenté sur la figure 7, les couches 116 et 122 présentes sur la couche 112 sont ensuite retirées, par exemple par gravure chimique (par exemple en utilisant une solution de HF). Les couches 110, 118 et 120 présentes sur la deuxième face 106 du substrat 102 sont également retirées.

Des couches antireflet, comprenant par exemple du SiN:H, sont ensuite réalisées en faces avant et arrière de la structure réalisée, c'est-à-dire sur la deuxième face 106 du substrat 102 et sur la couche 112. Sur la figure 8, ces couches antireflet portent les références 126 et 128. Les couches antireflet 126, 128 sont par exemple réalisées par dépôt PECVD.

La cellule 100 est achevée en réalisant des électrodes de contact avant et arrière du côté des faces avant et arrière de la cellule 100. Dans le premier mode de réalisation décrit ici, des électrodes de contact avant 130 sont réalisées à travers la couche antireflet 126 et sont en contact avec les deuxièmes régions 124 du substrat 102, et des électrodes de contact arrière 132 sont réalisées à travers la couche antireflet 128 et sont en contact avec la couche 112. Les électrodes de contact 130, 132 sont par exemple réalisées par impression d'une pâte de sérigraphie métallique, puis un recuit de la pâte de sérigraphie déposée.

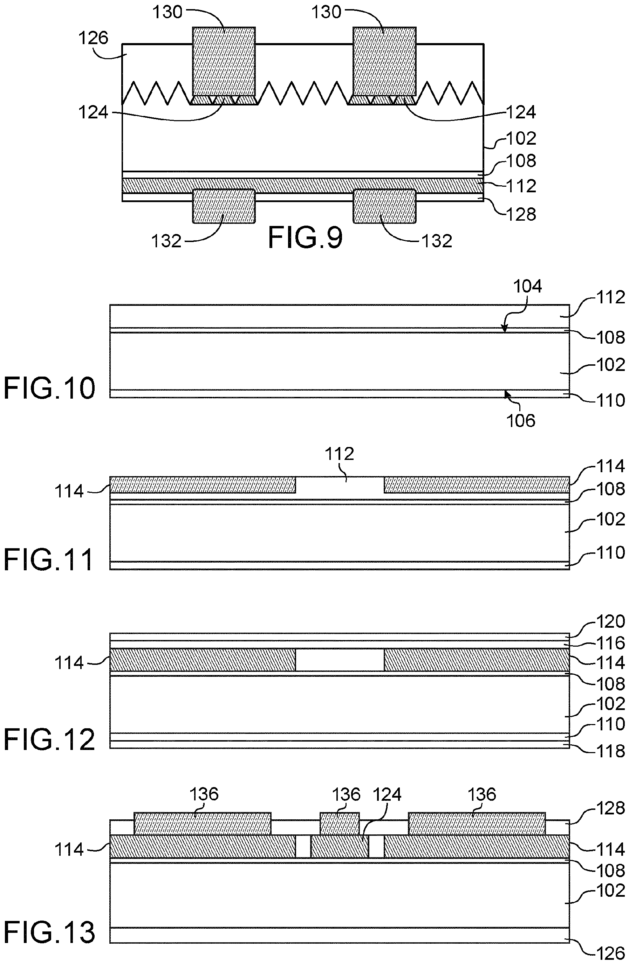

Un procédé de réalisation d'une cellule photovoltaïque 100 selon un deuxième mode de réalisation est décrit ci-dessous en lien avec les figures 10 à 13. Dans ce deuxième mode de réalisation, la cellule photovoltaïque 100 correspond à une cellule de type IBC.

La cellule 100 selon le deuxième mode de réalisation est réalisée à partir du substrat 102 qui est par exemple similaire à celui précédemment décrit pour le premier mode de réalisation. De plus, comme dans l'exemple de réalisation décrit précédemment, la deuxième face 106 du substrat 102 est destinée à se trouver du côté de la face avant de la cellule 100 et la première face 104 du substrat 102 est destinée à se trouver du côté de la face arrière de la cellule 100.

Sur l'exemple décrit ici, les faces 104 et 106 du substrat 102 ne sont pas texturées. En variante, une étape de texturation de la première face 104 et/ou de la deuxième face 106 du substrat 102 peut être mise en œuvre. De préférence, la deuxième face 106 destinée à se trouver du côté de la face avant de la cellule 100 est texturée, comme dans le premier mode de réalisation.

La couche de passivation 108 est ensuite réalisée sur la première face 104 du substrat 102, par exemple de manière similaire au premier mode de réalisation. En outre, du fait que la couche de passivation 108 est, dans cet exemple, formée par oxydation thermique, une fine couche d'oxyde 110 similaire à la couche de passivation 108 est également formée sur la deuxième face 106 du substrat 102.

La couche 112 de semi-conducteur polycristallin est ensuite réalisée sur la couche de passivation 108, par exemple comme précédemment décrit pour le premier mode de réalisation. La structure obtenue à ce stade du procédé est représentée sur la figure 10.

Une implantation ionique, par exemple par immersion plasma, de dopants de type p dans une ou plusieurs premières régions 114 de la couche 112 est ensuite mise en œuvre (voir figure 11). Dans le deuxième mode de réalisation décrit ici, les dopants de type p correspondent à des atomes de bore. En outre, dans le deuxième mode de réalisation décrit ici qui porte sur la réalisation d'une cellule photovoltaïque de type IBC, les dopants sont implantés dans différentes premières régions 114 de la couche 112. Les paramètres de mise en œuvre de cette implantation sont par exemple similaires à ceux de l'implantation mise en œuvre dans le premier mode de réalisation. En outre, afin de localiser l'implantation dans les premières régions 114, un masque dont le motif délimite ces premières régions 114 vis-à-vis du reste de la couche 112 est utilisé afin de ne pas implanter de dopants dans les autres régions de la couche 112.

En variante, cette implantation ionique peut être mise en œuvre par faisceau d'ions.

Comme dans le premier mode de réalisation, la structure réalisée est ensuite soumise à un recuit sous atmosphère oxydante, permettant de diffuser dans toute l'épaisseur de la couche 112 les dopants implantés dans les premières régions 114, d'activer ces dopants, et de former également les couches d'oxyde de semi-conducteur 116, 118.

La couche dopante 120 est ensuite réalisée. Contrairement au premier mode de réalisation dans lequel la couche dopante 120 est réalisée du côté de la deuxième face 106 du substrat 102, la couche dopante 120 est ici réalisée du côté de la première face 104 du substrat 102, sur la couche d'oxyde 116 (voir figure 12). Les caractéristiques de la couche dopante 120 réalisée sont par exemple similaires à celles de la couche dopante 120 précédemment décrite en lien avec le premier mode de réalisation.

La présence de la couche d'oxyde 116 sur la couche 112 permet de préserver cette couche 112, et notamment les premières régions 114 de cette couche 112, vis-à-vis des dopants présents dans la couche dopante 120 et évite une diffusion des dopants du deuxième type de conductivité (phosphore dans cet exemple de réalisation) depuis la couche dopante 120 jusque dans la couche 112 lors de la réalisation de la couche dopante 120.

L'étape de diffusion, ou sur-dopage, localisée des dopants du deuxième type de conductivité est ensuite mise en œuvre. Contrairement au premier mode de réalisation dans lequel cette diffusion est réalisée pour diffuser les dopants dans des deuxièmes régions 124 du substrat 102, la diffusion localisée mise en œuvre dans ce deuxième mode de réalisation permet de diffuser les dopants depuis la couche dopante 120 dans des deuxièmes régions 124 de la couche 112. Dans l'exemple de réalisation décrit ici, cette étape de diffusion localisée est mise en œuvre en exposant certaines zones de la face arrière de la structure réalisée à un faisceau laser, ce qui permet de fortement diffuser les atomes depuis la couche dopante 120 jusque dans les deuxième régions 124 de la couche 112 exposées à ce faisceau laser. Les deuxièmes régions 124 formeront des régions émettrices de la cellule 100.

Cette étape de diffusion localisée est mise en œuvre directement après la réalisation de la couche dopante 120, sans étape de recuit de diffusion, ou « drive in », mise en œuvre entre la réalisation de la couche dopante 120 et la diffusion localisée.

La couche dopante 120 et la couche d'oxyde 116 sont ensuite retirées exemple par gravure chimique (ici en utilisant du HF). Les couches d'oxyde 110 et 118 présentes sur la deuxième face 106 du substrat 102 sont également retirées par cette gravure.

La cellule 100 selon le deuxième mode de réalisation est ensuite achevée en réalisant les couches antireflet 126, 128 en face avant et arrière de la structure réalisée, puis en réalisant des premières et deuxième électrodes de contact 134, 136 qui, dans ce deuxième mode de réalisation, sont localisées uniquement en face arrière de la cellule 100 (voir figure 13). Les premières électrodes de contact 134 sont en contact avec les premières régions 114 de la couche 112, et les deuxièmes électrodes de contact 136 sont en contact avec les deuxièmes régions 124 de la couche 112. Ces premières et deuxièmes électrodes de contact 134, 136 sont par exemple réalisées par sérigraphie puis recuit de la pâte de sérigraphie déposée, comme dans le premier mode de réalisation, à travers la couche antireflet 128.

Dans les exemples de réalisation décrits ci-dessus, la réalisation d'une seule cellule photovoltaïque 100 est décrite. Ce procédé peut toutefois être mis en œuvre pour la réalisation simultanée de plusieurs cellules photovoltaïques.

Les variantes précédemment décrites en lien avec le premier mode de réalisation peuvent s'appliquer également au deuxième mode de réalisation.

## Revendications

1. Procédé de réalisation d'au moins une cellule photovoltaïque (100), comportant au moins la mise en œuvre des étapes de :
- réalisation d'une couche de passivation (108) sur au moins une première face (104) d'un substrat semi-conducteur (102) ;
- dépôt d'une couche de semi-conducteur polycristallin (112) sur la couche de passivation (108) ;
- implantation ionique de dopants de type p dans une ou plusieurs premières régions (114) de la couche de semi-conducteur polycristallin (112) ;
- recuit sous atmosphère oxydante, diffusant et activant les dopants de type p dans la couche de semi-conducteur polycristallin (112) et formant au moins une couche d'oxyde de semi-conducteur (116) sur la couche de semi-conducteur polycristallin (112) ;
- réalisation, sur une deuxième face (106) du substrat semi-conducteur (102), opposée à la première face (104), et/ou sur la couche d'oxyde de semi-conducteur (116), d'une couche dopante (120) incluant des dopants de type n ;
- diffusion localisée des dopants de type n dans une ou plusieurs deuxièmes régions (124) du substrat semi-conducteur (102) ou de la couche de semi-conducteur polycristallin (112), la ou les deuxièmes régions (124) étant localisées sous la couche dopante (120) et distinctes de la ou des premières régions (114) ;
et dans lequel la couche d'oxyde de semi-conducteur (116) est conservée sur la couche de semi-conducteur polycristallin (112) lors de la réalisation de la couche dopante (120) et lors de la diffusion localisée des dopants de type n.

2. Procédé selon la revendication 1, dans lequel la diffusion localisée est mise en œuvre directement après la réalisation de la couche dopante (120), sans étape de recuit de diffusion entre la réalisation de la couche dopante (120) et la diffusion localisée.

3. Procédé selon l'une des revendications précédentes, dans lequel les dopants de type p correspondent à des atomes de bore, et les dopants de type n correspondent à des atomes de phosphore.

4. Procédé selon l'une des revendications précédentes, dans lequel :
- le recuit sous atmosphère oxydante est mis en œuvre à une température comprise entre 850°C et 1000°C et pendant une durée comprise entre 10 à 60 minutes, et/ou
- la réalisation de la couche dopante (120) est mise en œuvre à une température comprise entre 750°C et 850°C et pendant une durée comprise entre 5 minutes et 1 heure.

5. Procédé selon l'une des revendications précédentes, dans lequel la couche dopante (120) comporte du PSG, et/ou la couche de passivation (108) comporte de l'oxyde de semi-conducteur.

6. Procédé selon l'une des revendications précédentes, dans lequel l'atmosphère oxydante correspond à une atmosphère de dioxygène.

7. Procédé selon l'une des revendications précédentes, dans lequel le substrat semi-conducteur (102) et la couche de semi-conducteur polycristallin (112) comportent du silicium.

8. Procédé selon l'une des revendications précédentes, dans lequel l'implantation ionique des dopants de type p correspond à une implantation ionique par immersion plasma.

9. Procédé selon l'une des revendications précédentes, comportant en outre, après la diffusion localisée, un retrait de la couche d'oxyde de semi-conducteur (116).

10. Procédé selon la revendication 9, dans lequel, lorsque la diffusion localisée diffuse les dopants de type n dans la ou les deuxièmes régions (124) du substrat semi-conducteur (102), le procédé comporte en outre, après le retrait de la couche d'oxyde de semi-conducteur (116), un dépôt de couches antireflet (126, 128) du côté de la première face (104) du substrat semi-conducteur (102) et du côté de la deuxième face (106) du substrat semi-conducteur (102), puis la réalisation, à travers les couches antireflet (126, 128), d'électrodes de contact arrière (132) sur la couche de semi-conducteur polycristallin (112) et d'électrodes de contact avant (130) sur les deuxièmes régions (124) du substrat semi-conducteur (102).

11. Procédé selon l'une des revendications 1 à 9, dans lequel, lorsque la diffusion localisée diffuse les dopants de type n dans la ou les deuxièmes régions (124) de la couche de semi-conducteur polycristallin (112), le procédé comporte en outre, après la diffusion localisée, un dépôt de couches antireflet (126, 128) du côté de la première face (104) du substrat semi-conducteur (102) et du côté de la deuxième face (106) du substrat semi-conducteur (102), puis la réalisation, à travers l'une des couches antireflet (128) se trouvant du côté de la première face (104) du substrat semi-conducteur (102), d'au moins une première électrode de contact (134) sur la ou les premières régions (114) de la couche de semi-conducteur polycristallin (112) et d'au moins une deuxième électrode de contact (136) sur la ou les deuxièmes régions (124) de la couche de semi-conducteur polycristallin (112).

12. Procédé selon la revendication 11, dans lequel les premières et deuxièmes électrodes de contacts (134, 136) sont interdigitées.

13. Procédé selon l'une des revendications 10 à 12, dans lequel la réalisation des électrodes de contact avant et arrière (130, 132) ou la réalisation des premières et deuxièmes électrodes de contact (134, 136) comporte au moins un dépôt par impression d'une pâte de sérigraphie, puis un recuit de la pâte de sérigraphie.

14. Procédé selon l'une des revendications précédentes, comportant en outre, avant la réalisation de la couche de passivation (108), une texturation de la première face (104) et/ou de la deuxième face (106) du substrat semi-conducteur (102).
